(19) Europäisches Patentamt
European Patent Office
Office européen des brevets

(11) **EP 2 096 453 B1**

(12) **EUROPEAN PATENT SPECIFICATION**

(45) Date of publication and mention
of the grant of the patent:
**25.03.2015 Bulletin 2015/13**

(21) Application number: **08102134.7**

(22) Date of filing: **28.02.2008**

(51) Int Cl.:
*G01R 31/36* (2006.01)    *H02J 7/00* (2006.01)
*B66F 9/06* (2006.01)    *B60L 3/00* (2006.01)
*B60L 11/18* (2006.01)    *B66F 9/075* (2006.01)
*B66F 9/24* (2006.01)

(54) **Battery status assessment**

Beurteilung des Akkustatus

Évaluation de l'état d'une batterie

(84) Designated Contracting States:
**DE FR GB IT SE**

(43) Date of publication of application:
**02.09.2009 Bulletin 2009/36**

(73) Proprietor: **BT Products AB**
**595 81 Mjölby (SE)**

(72) Inventor: **Valfridsson, Göran**
**595 54 Mjölby (SE)**

(74) Representative: **Zacco Sweden AB**
**P.O. Box 5581**
**114 85 Stockholm (SE)**

(56) References cited:
**US-A- 5 808 445**    **US-A1- 2003 169 019**
**US-A1- 2004 100 225**    **US-A1- 2007 182 576**

## Description

### TECHNICAL FIELD

The present invention relates to the field of material handling vehicles, in general. It relates in particular to a method used associated with an industrial material handling vehicle or fleet of material handling vehicles.

### BACKGROUND ART

Battery condition monitoring and recording systems for electric cars are known in the prior art. These systems are based on additional equipment added to the car; sensors and other equipment are attached to the battery for performing the monitoring and recording. This means that all batteries to be monitored are modified. Such a system is known from US 5 349 535, wherein a determination of the cell charge state, usage and remaining life is performed based on parameters such as sensors measuring the battery voltage, current into or out of the pack, ambient or cell temperature and specific gravity of the electrolyte. One of the disadvantages of this system is that a additional equipment as installation of said sensors for example on the battery packs are needed. Another disadvantage is that it is only directed to measure directly on the said battery pack and does not take into account other parameters which are associated with the usage of the vehicle, or the particular driver. Another disadvantage is that it does not deal with the particulars of a material handling vehicle where in most cases the energy in the battery are used also for lifting and other particulars.

Further related documents includes US2004/0100225A1 which relates to a method for predicting remaining battery charge and US2007/0182576A1) which relates to a method for tracking and managing battery charge level for industrial trucks. However none of these documents relate to the problem of monitoring battery condition.

### SUMMARY OF THE INVENTION

One or several of the disadvantages above are solved by the method of the present invention according to claim 1.

The effect of this is an assessment of the battery status without any modifications of the battery in said vehicle. Also particulars of operational data of a material handling vehicle are taken into account. Also the method provides for identifying if the battery has lost its capacity for example by a bad cell, aging, inferior maintenance etc. Another effect is that its possible to Identify if the battery is operated to too low battery discharge rates by manually overriding of control system for the battery of the driver.

An industrial material handling vehicle is a vehicle that in general comprises a material handling arrangement. This arrangement is most generally situated in one end of said material handling vehicle and comprises a carrying device and a lifting device. The carrying device is generally arranged together with the lifting device, such as the particular case of a lifting mast and forks. The lifting device have many possible configurations such as having lifting mast section telescopically arranged together for allowing higher lifting. The lifting device can also be arranged without a mast for lower lifting applications. The lifting mast can be arranged to comprise several carrying devices, it can also be configured to allow the carrying device to move in any direction so that a load can be placed independently of the main direction the material handling vehicle. The carrying device is generally arranged as a pair of forks, but single fork and other configurations is imaginable, as well as carrying devices not comprising forks but other configurations such as barrel carrying, hook carrying, magnetic carrying. It is also imaginable within the scope of the invention where the carrying part is adapted for carrying smaller units not needing a mast to be lifted, such as smaller units handled manually by an operator. The material handling device can be arranged to carry the operator as well as the material. However material handling vehicles where the operator can walk or transport himself without aid from the vehicle are also imaginable with in the scoop. The general material handling vehicle has at least three wheels and at least one wheel that is powered. However non powered material handling vehicles are also within the scoop such as hand trucks and non powered or partly powered vehicles. Further are there often support wheels of different kind such as swivelling wheels and support leg wheel. The brake of a material handling vehicle can operate on the drive wheel. The brake can also operate any other wheel of the vehicle. I can of course operate on several of these wheels at a time.

The lifting arrangement of the material handling vehicle generally comprises a hydraulic arrangement for lifting movements. This arrangement comprises a hydraulic pump and associated piston or pistons and hydraulic pipes.

The hydraulic arrangement can be used alone with a lifting device being associated more or less directly with the load carrying device. Other solutions are for example the use of chains in an hoist chain arrangement.

Generally material handling vehicles of today has a logic unit which is used for gathering data of the vehicle and also for handling and directly operating the vehicle.

To power a material handling vehicle there are several options, such as electricity, combustion engines, and hybrid power. The present invention deals mainly with electrically driven material handling vehicles, but could be of use in an arrangement where a smaller battery is used together with another power source such as in the more frequent hybrid powered vehicles of today.

In one example the operational data registered by the operational data unit comprises data related to at least one of the following parameters: lift time or drive time, preferably both.

The effect of this is that there is taken into consideration how the material handling vehicle is operated for the assessment of the battery status.

In one example operational data related to at least one of the parameters:

accumulated lift time, accumulated drive time, and driver identification such as a driver pin, battery discharge rate, is registered by the operational data unit , at the start of a work pass.

In particular the driver pin allows for identification of the operator or driver so that battery status can be taken into account for the particulars of the person operating it.

In one example operational data related to at least one of the parameters, time stamp, work pass ending type is registered at end of work pass, by the operational data unit.

In one example the work pass ending type registered by the operational data unit, has at least three possible values denoting, normal ending, timer logoff ending and power loss ending.

The effect of this is identification whether the vehicle is not turned off in the proper manner.

In one example the battery status calculated by the logic unit or the server is indicated by a battery status indicator.

In one example the method comprises determining by the logic unit or the server, a warning level based on the calculated battery status and indicating the warning level.

In one example the said warning has at least two levels, a first grade and a second grade and that these two warning's is displayed in a different manner, and that said warnings arises from different values of said battery status, calculated by said logic unit or said server.

In one example the assessment of the battery status comprises:

- registering an operational data comprising measuring power off time by the operational data unit

- calculation of battery status based on power off time information by the logic unit or server
and further

- indication of a short time charging warning based on said power off time by a battery discharge indicator

An effect of this is that the method provides for indentifying if the battery are not charged in a proper manner, and are loosing its charge rate at usage.

In one example the registering battery discharge rate data comprises:

- registration of battery discharge rate at end of working pass by an operational data unit indicated by a BDI
registering operational data comprises:

- registering of power off time by the operational data unit
calculating the battery status by the logic unit or the server comprises:

- determining by the logic unit or the server whether the power off time between two working passes has been less than a predetermined value.

- determining by the logic unit or the server whether the battery discharge rate is lower than a predetermined value

- determining by the logic unit or the server whether the battery discharge rate is comprised in a predetermined interval at the start of new working pass.
In one example a first grade short time charging warning is generated if

- the logic unit or the server determines that the conditions of the ones mentioned above, has been valid at least a predetermined number of times during the last predetermined amount of working passes.

In one example a first grade rapid discharge warning is generated by the logic unit or the server if the conditions above are met a predetermined amount of times of changes from A to B.

In one example a second grade rapid discharge warning is generated by the logic unit or the server if the following condition is complied with:

- parameter Y is less predetermined value H where H is less than G.

and this condition are determined by the logic unit or the server is met a predetermined amount of times.

In one example a power loss warning is generated based on power loss and one other condition, such as a condition above.

In one example a first grade power loss warning is generated as a result of the following further steps:

- Determining by the logic unit or server that working pass is ongoing.

- Determining by the logic unit or server that power is lost.

- Determine by the logic unit or server if the conditions above are met a predetermined amount of times.

In one example is further comprised an interface for communication with the said server, said interface is preferably of wireless kind being able to communicate over wireless systems such as, GSM, GPRS, LAN, Satellite networks.

In one example said interface is arranged to use a Short Message Text Service for communicating said data.

Also disclosed is a computer program product adapted to perform the above method.

Its also disclosed a device for performing the method described above for assessment of battery status in a vehicle such as an electric material handling vehicle, comprising a battery discharge indicator, an operational data unit for collecting operational data in the material handling vehicle, and logic unit or a remote server for performing a calculation for assessment of the battery status and the device is arranged for using the collected data for a battery status calculation, where said logic unit or remote server calculates the status of the battery based on measurement of an operational condition registered by the operational data unit and a battery discharge rate value, indicated by the battery discharge indicator.

The device may comprise an interface for transmitting the registered data or the warnings of the method to the remote server.

The device may comprise a battery status indicator for presenting transmitted data or warnings to a user after execution of the method.

BRIEF DESCRIPTION OF THE DRAWINGS

Fig. 1 discloses an example of a material handling vehicle.

Fig. 2 discloses an outline diagram of the measured voltages for a battery discharge indicator.

Fig. 3 discloses a generic diagram of a graph used to determine the battery discharge rate.

Fig. 4 discloses a block scheme of the device with its units of the invention

Fig. 5 discloses a block scheme for the operational data unit

Fig. 6 discloses a scheme for the relation between the first and second grade warnings.

Fig. 7 discloses a scheme for the method of the invention.

Fig. 8 discloses a block scheme for an example of the invention

DETAILED DESCRIPTION

On a material handling vehicle 1 the carrying arrangement comprises generally elongated forks 14. The forks 14 are arranged to be able to lift a load, such as a pallet. The pallet has generally standard sized dimensions with a pair of tunnels for receiving the forks 14 of the material handling vehicle. The material handling vehicle 1 in general is arranged to use its ability to drive forward and backwards to insert the forks in said pallet. Other arrangements are possible where the forks 14 can be moved forward and backwards without the movement of the complete material handling vehicle

1. The forks 14 are fitted to a sledge 15 that slides along a mast 16. Alternatively the forks are fitted directly to a hydraulic arrangement without a mast 16 and sledge 15. The hydraulics of the material handling vehicle 1 generally comprises a hydraulic pump, pipes and valves for providing high lifting capability. Even the smallest hand trucks are able to lift loads up to 1000 kg. The material handling vehicle 1 is generally operated in a manner where the number of stops and drives accumulates very quickly during a work pass. This means that the operation of the material handling vehicle and accordingly the status of the battery of the material handling vehicle can be difficult to predict since there need not be a standard route which the operator follows.

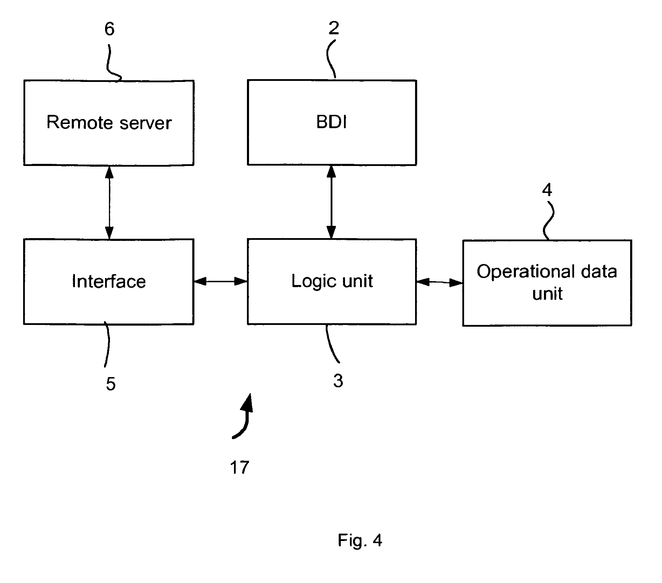

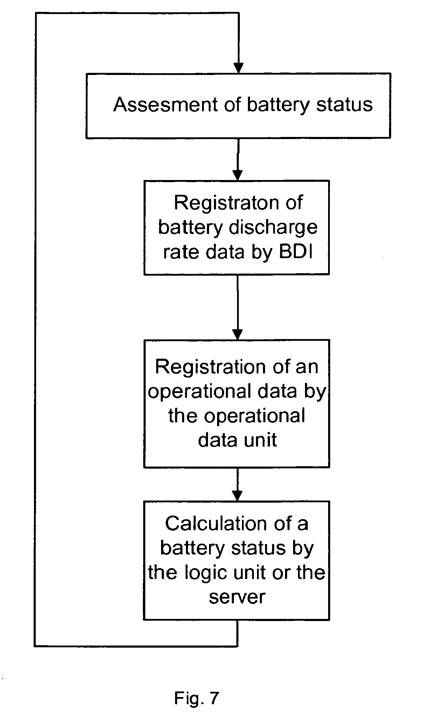

The battery status of a battery is herein to be understood as a measure on the ability of the battery to perform its tasks. This means that the status is associated with operational characteristics of the battery registered by an operational data unit 4, se fig 4, se also fig. 7. The battery status is not to be confused with the remaining energy in the battery. The remaining energy in the battery is measured by a battery discharge indicator, BDI 2. The battery status is an assessment of the condition of the particular battery or batteries which is based on the operation and maintenance of the battery and provides a tool for decisions on maintenance or battery change. This is done without any addition of extra sensors or equipment on the vehicle 1 or battery. The status of the battery is also associated with the particular operator of the vehicle 1 in which the battery is comprised.

In fig. 4, the battery discharge indicator 2 communicates with a logic unit 3 of the material handling vehicle 1. Also operational data unit 4 communicates with the logic unit 3 of the vehicle 1. The logic unit 3 is arranged to calculate the battery status based on information from the BDI 2 and the operational data unit 4. Alternatively an interface 5 is arranged to transmit the operational data and the BDI data to a remote server 6 for calculation and assessment of the battery status, see fig 4. If the server 6 performs said calculation the logic unit 3 is arranged to transmit and/or store the data needed for said calculation.

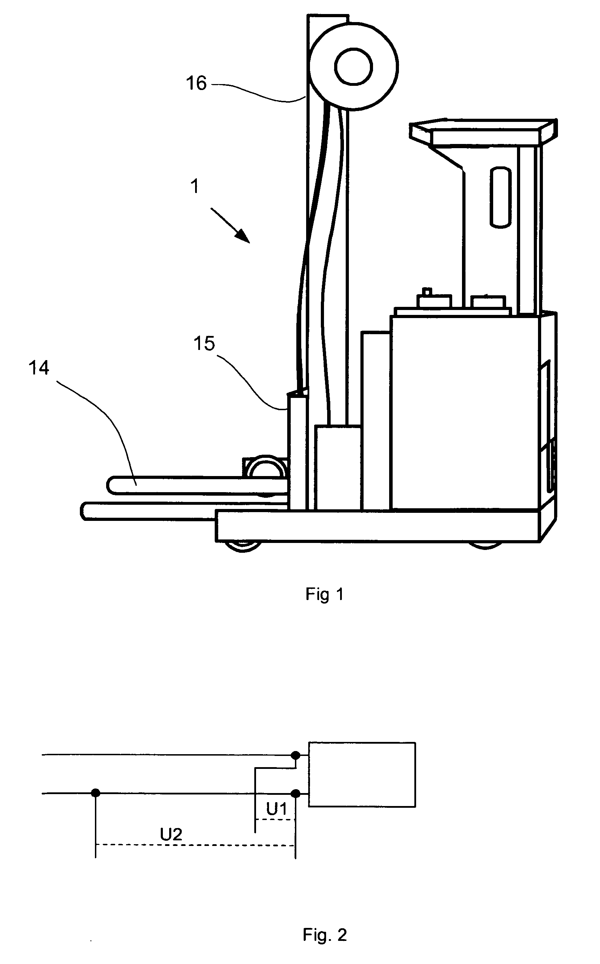

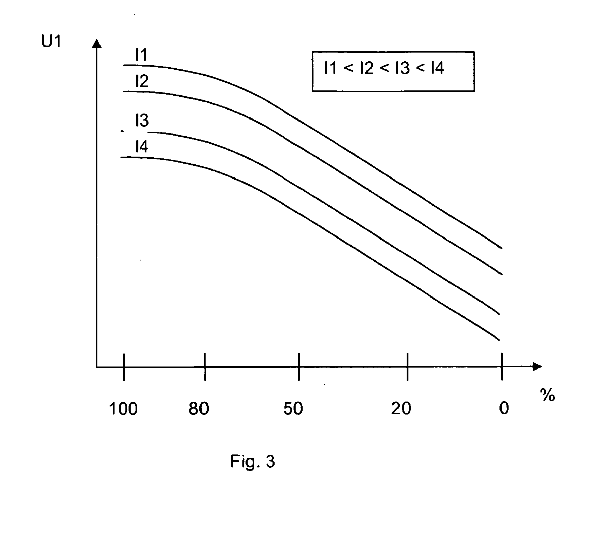

In one example the BDI 2 measures two electric voltages, U1 and U2. Fig. 2 demonstrates one example of the configuration of the BDI 2. U1 designates the terminal voltage of the battery or a cell of a battery. U2 designates an electric voltage measured along a conductor from said battery. By comparing U1 with a current I calculated based on the measured U2 a remaining energy % is provided through a standard graph such as the one displayed in Fig.3. The measurement in % is based on a theoretical value of 100%, corresponding to a battery that is fully charged, i.e. the battery discharge rate is 100 %. Of course 100 % is not to be taken as an exact value. Other percentages are possible depending on the accuracy of the BDI and the battery characteristics. The amount of ampere hours corresponding to 100 % is of course varying with the battery or cell size. Preferably the % of the BDI is a theoretical value corresponding to a scale where 0 % corresponds to 20 % real remaining energy in the battery. And the calculations and assessment of the battery status is based on this scale. Using the battery until its fully drained of energy is harmful for the battery. This means of course that a different graph as the one of Fig. 3 can apply if the battery is changed to another battery with another capacity than the original battery. The remaining energy level can be presented to an operator. This presentation can be performed through a display associated with other presentations of for example speed, travelled distance, lifting height etc.

In one other example the BDI is made through obtaining the current from the standard engine controlling unit. This data can be provided through CAN. Other ways of measuring a BDI is imaginable and the usage of a shunt to provide this is possible. Also the voltage U1 can be measured in other ways and not only the terminal voltage is possible to use.

The operational data unit 4 is arranged to register operational data related to the operation of the material handling vehicle 1 during a work pass of the vehicle 1. And further the operational data unit 4 is arranged to transmit its data. The operational data unit 4, could in one example, not shown communicate with the server 6 through an interface 5. The operational data unit 4 can in one example not shown, be comprised in the logic unit 3.

The operational data unit 4 is in one example, arranged to register the work pass related operational data. The work pass determination unit 8 determines the work pass. A work pass herein defined as a time period which starts when the driver logs on to the logic unit 3 of the material handling vehicle. The work pass ends when the driver logs off the logic unit 3 of the material handling vehicle 1. Other definitions of a work pass are of course also imaginable, for example solutions where the driver doesn't need to log on manually i.e. where he is logged on automatically. For example a work pass is determined to start when the operator first start to take out energy from the battery for example when an energy consuming mechanism is put into service on the vehicle 1. A work pass is also ended when the power is lost.

The operational data unit 4 is in one example further arranged to register the number of drives. This is done by the unit for determination of number of drives 13. The number of drives is an integer which is defined by a start and a stop of the vehicle. This could be measured in several ways. One way of measuring the number of drives is to define a consecutive start and a stop movement of one or several wheels of the vehicle as one drive. Another way of measuring the number of drives is to define one drive as a start movement of one or several wheels of said vehicle. Other possible ways of measuring a drive is imaginable as for example when the vehicle 1 by measuring a start and stop of the drive engine of the vehicle or a measurement of the start of the drive engine.

The drive time registered by the operational data unit 4 is defined as the time between a start and a stop of the vehicle. Drive time can also be defined by a measurement of start and stop of one or several wheels Drive time can also be defined as start and stop of the drive engine. Drive time is determined by the drive time determination unit 11.

The operational data unit 4 is in one example also arranged to register the lift time. Lift time is determined by a lift time determination unit 17. Lift time can be defined in several ways. One definition is that a lift time is defined as a time period starting with lift engine start and ending with lift engine stop. Other definitions are possible such as when the forks of the material handling vehicle alter position in an energy consuming way, or definitions based on energy consumption of the lift engine.

Lift time and drive time are generally not related to each other. They can be measured independently. Approximations of drive time and lift time are also possible where overlapping time periods are dealt with as either a drive or a lift time period.

The operational data unit 4 is in one example also arranged to register the number of lifts of the vehicle 1. The number of lifts is measured in any standard way. Possible ways of measuring the number of lifts are the usage of a change of direction of the carrying means in the material handling vehicle 1. Many other ways of measuring this is imaginable such as a signal from the actuator of the lifting device.

The operational data unit 4 is in one example also arranged to register data related to accumulated drive and lift time. The accumulated drive time and lift time is the time period when the vehicle is operating drive or lift from start of operation of said vehicle.

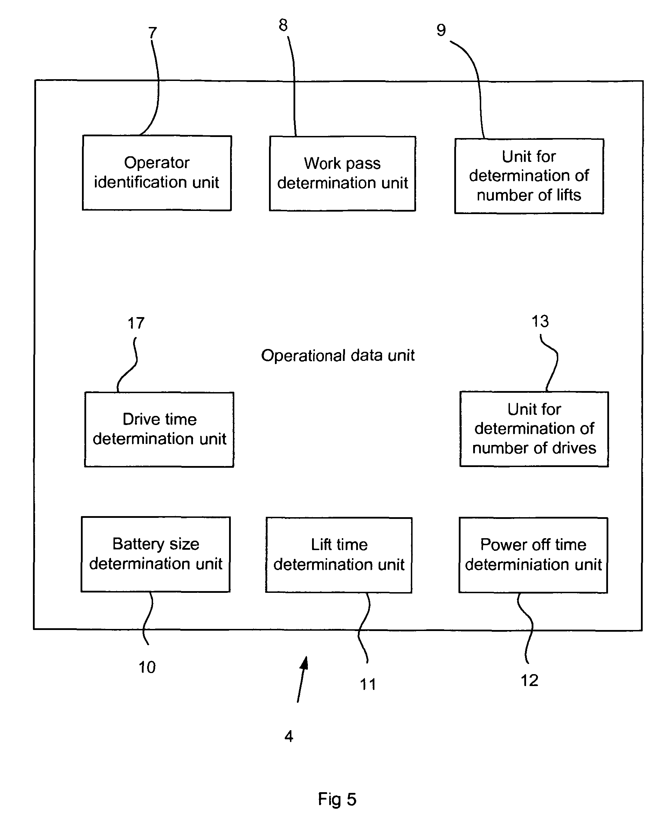

Another operational data registered in one example, by the operational data unit 4 is driver or operator identification, see fig 5. Means for operator identification are also present in the material handling vehicle 1. Said means are in one example an operator identification unit 7. The operator identification is provided by a personal pin code, e. g. a number of figures. Other means of identification are possible such as keys or automatic wireless identification such as RFID technology. The identification can be used to obtain operational data on a personal level for evaluation of drive behaviour. As the battery status of the invention is based on operational data which are affected by the operators operation of the vehicle, an evaluation of respective operator is possible. The identification of the driver is preferably performed at the start of a work pass.

The operational data unit 4 registers the ending type of a work pass. The ending type of a work pass is relevant for the battery status. The work pass ending type can generally comprise three ending types. The work pass ending type is registered at the end of a work pass. The ending type is defined as normal when the ending was not forced upon the operator without its consent. Another types of work pass ending is timer logoff ending. Timer log off ending of the work pass appears when a predetermined time period ends that is set by an administrator of the material handling vehicle. Another ending of the work pass is a power loss ending. The power loss ending of the work pass occurs when the battery discharge rate is below a predetermined value. This value is generally set by an operator. Another power loss ending is when an actual power loss appears e.g. when the battery is completely drained out of energy. The power loss ending of the work pass can also occur when the power for other reasons is ended; this could for example be when a cable is cut or removed from the battery either by accident or on purpose, as when the electrical connection to the battery is removed.

Operational data unit 4 is one example fitted with a battery size determination unit 10. This unit 10 can receive data manually of the battery size. The unit 10 can in one example use known technology to automatically determine the battery size.

The operational data unit 4 is arranged to time stamp at least some of the registered operational data.

The logic unit 3, can also be denoted a data handling unit or a vehicle computer. The logic unit 3 is generally a computer which is arranged to register data and to perform calculation, for the operation of the vehicle 3. The logic unit 3 comprises a RAM and a ROM memory of any standard configuration and size. It also comprises a processor. Other components are in and out ports for receiving and sending data. The data can be instructions to elements of the material handling vehicle or other the data discussed above.

The method also comprises the possibility of using an interface 5, as mentioned earlier, for sending registered data from the vehicle to another logic unit 6, such as a server 6, see fig 4. Such interface 5 can be arranged to be comprised in the charging cable of the material handling vehicle 1. In another example it can preferably be of a cordless type, such as a LAN, or even more preferably of a type that uses the mobile networks such as a network comprising GPRS type functionality. Other interfaces 5 which can communicate via SMS, short message service of the mobile network is also possible. There are also imaginable to use other cordless interfaces which uses for example a 3G network or CDMA or other any other mobile network. The interface 5 can also use communication over a satellite network such as the Iridium™ network. Other possibilities are a network cable communication, where an administrator attaches his logic unit physically by a cable, to the logic unit 3 or the operational data unit 4 and downloads data for battery status assessment. Other techniques are possible such as Bluetooth, or any other kind of wireless communication such as infrared or sound or light.

In the shown example assessment of the battery status it is performed in the logic unit 3 of the vehicle. Alternatively the assessments can also be performed by the remote server 6. When a remote server 6 is used for assessment of the particular material handling vehicles 1 the use of an interface via a mobile network is preferred.

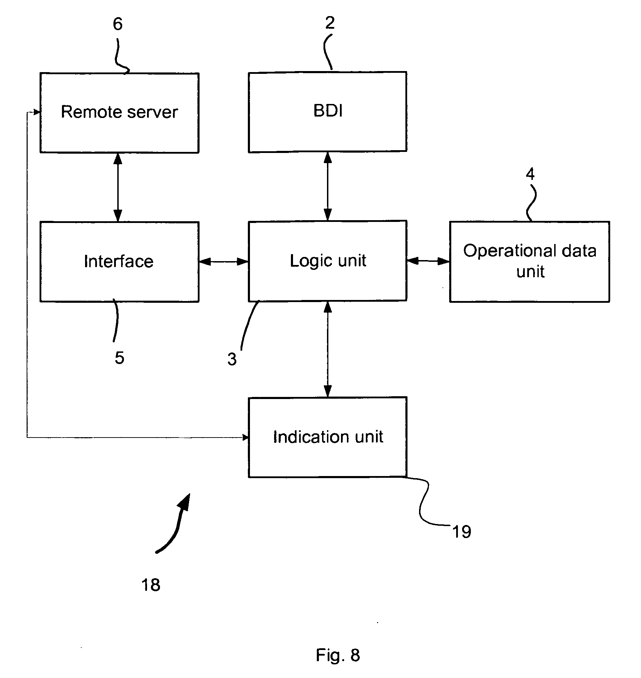

The method comprises the step of indication of the assessed battery status by a battery status indicator 19, see fig 8. If the status of the battery is normal the indication is a normal indication without any warning. Another possible indication is when the battery status indicator 19 is turned off. If the status of the battery needs attention the battery status indicator indicates a warning.

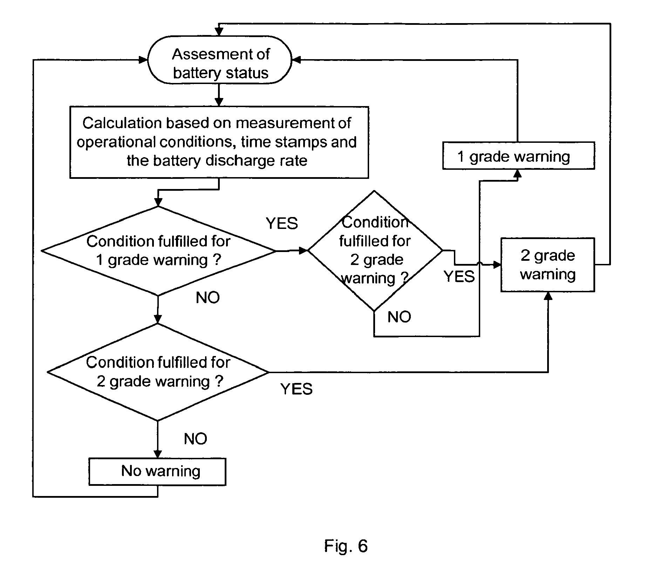

The warning of the battery status indicator 19 has levels associated with said battery status. Two main levels of said warning are determined in the method of assessment of the battery status as a first grade warning and a second grade warning. The first grade warning is a recommendation for checking the battery of the vehicle 1. The second grade warning is associated with different value of the battery status than the said first grade. The second grade warning is a must check warning. If this warning occurs the battery in question must be checked. In one example the logic unit 3 or 6 determining the level of warning uses a logic described in fig. 6, for the relationship between the warning levels.

Deep analysis of the battery status can be performed, if an administrator needs more information after receiving warnings there is a possibility to list data in order and see where the particular warning condition was fulfilled and what warning this resulted in. In this way the administrator can use single work passes to determine manually that something happened. This could be done by a graph or a list of work passes or the like. This could be particularly useful if several batteries are used in the same vehicle.

In one embodiment of the method of the battery status determinates a first grade short time charging warning in the following manner:

No battery change is a precondition registered by the operational unit 4. The operational unit 4 sends data of power off time between two working passes. The logic unit 3 or server 6 determines if the power has been off, but less than a predetermined time period. In one example the preferred time period is less than 1 hour more preferably less than 45 minutes or most preferably less than 30 minutes. If the battery discharge rate at the end of the work pass is less than a predetermined value. This predetermined value is in one example equal or less than 50 % or equal or less than 40 % or equal or less than 30 % or less than or equal to 20 %. And if at the start of a new consecutive work pass the battery discharge rate larger than said predetermined value. In one example this corresponds to an interval between 80 and 100 % or 90 and 100 %, more preferably in at least 95 % or more preferably at least 100 % or above. And if condition imposed is valid at least a predetermined amount of times during the last consecutive work passes. The predetermined amount of work passes are two to four preferably three. Then the battery status is determined by the logic unit 3 or the server 6 as generating a first grade warning.

The power off time is defined as the time between two working passes. The power off time is generally used as an accumulated value where the measured power off times as added to an accumulated value. Power off time is determined by the power off time determination unit 12, see fig 4.

In one embodiment of the method of the battery status determinates a second grade short time charging warning in the following manner:

> The first conditions are the same as for the first grade warning. However if the logic unit 3 or the server 6 determines that the conditions are fulfilled at least a predetermined amount of times that is larger than for the first grade warning, then a second grade warning is generated. Preferably the second grade warning is generated if the conditions are fulfilled at least, five times during the last ten consecutive work passes,

> In one embodiment the logic unit 3 or the server 6 of the battery status determinates a first grade rapid discharge warning in the following manner:

The logic unit 3 or the server 6 in receiving data from the BDI 2 determines that the battery discharge rate changes from a predetermined value A to another predetermined value B where A > B.
Preferably is the chosen interval an interval where the BDI gives an essentially linear value change of the battery discharge rate. A could for example be comprised between 100 and 60 %. In one example A is preferably essentially 60 %. B is in one example comprised between 40 and 20 % and B can be essentially 30 %. The method does not require that the consecutive change takes place during one single work pass.
And the logic unit 3 or the server 6 determines that an intermediate value C, where C > A, has not occurred during the change between A and B.

And the logic unit 3 or the server 6 performs a calculation of a parameter where:

$$Y = D*N/E$$

The logic unit 3 or the server 6 then determines if Y is less than a predetermined value G.
Y should be less than G a predetermined amount of changes from A to B with intermediate value C.
If the logic unit 3 or the server 6 determines that all this is fulfilled a first grade warning is generated.
During the consecutive change from the first value to the second value the operational unit 4 registers, D which is drive and lift time and accumulates it.
Y is preferably corresponding ton the drive and lift time per energy unit. Most preferably Y is expressed in minutes per 100 Ah. Of course other units are imaginable for expression of Y.
N is a constant. This constant is set so that the calculation of Y is essentially independent of the value of E. The value of N varies. In one example N is generally comprised in the interval between 600 and 200, more preferably between 500 and 300 and even more preferably between 450 and 350, an more preferred value is essentially 400, for values of E expressed in Ah. If other values of D and E are used N can be changed accordingly.
E corresponds to the energy size of the battery. E is in one example preferably expressed in Ampere hours, Ah. However it is of course imaginable to use other units for E. But the method must be changed accordingly.
For an informative value of Y parameter D is in one example expressed in minutes. Of course other measures as seconds and hours are possible but the other parameters must then be changed accordingly. This can be performed automatically in the logic unit 3 or the server 6.
G is in one example a value that generally could be comprised between 40 min and 20 min preferably between 35 min and 25 min. But other values are imaginable outside these intervals.
Preferably G is less than Y a predetermined number of times of changes from A to B without intermediate value C. One preferred value of the predetermined number of times is two out of five times, if no battery change is present. However other values of the predetermined number of times could be 2 out of 7 times 1 out of 5 times 1 out of 9 times or any suitable value such as 1 out of 1 times. If battery change is present the Y should be less than G, for example two out of ten times of changes from A to B without intermediate value C. However other filtering conditions are possible, such as one out of ten times or on out of 100 I.e. two batteries are used to replace each other. For three or more batteries used the filtering condition should be changed mutandis mutandis. It is of course imaginable that the predetermined amount of times for change from A to B without intermediate value C, is one out of one.

In one example of the method of the battery status the logic unit 3 or the server 6 determinates a second grade rapid discharge warning in the following manner:

The logic unit 3 or the server 6 performs the same calculation as for the first grade warning.

However the logic unit 3 or the server 6 determines that Y is less than predetermined value H, where H is less than G. A typical value of H is in one example comprised between 25 and 0 min and more preferably between 20 and 5 min. But other values are imaginable outside these intervals.

And if the logic unit 3 or the server 6 determines that Y is less than H is valid a predetermined number of changes from A to B without intermediate value C, then a second grade warning is generated. Typical values of the predetermined amount of times are two out of three times or two out of six times if battery change is present. Other values as for the first grade warning are imaginable such as one out of two times or one out of three times etc. for filtering.

In the one example of an embodiment of the method of the battery status is determined by the logic unit 3 or the server 6 and generates a second grade power loss warning in the following manner:

The operational unit 4 registers that the work pass is ongoing. This is transmitted to the logic unit 3 or the server 6. If the logic unit 3 or the server 6 determines that the power is lost. And if the logic unit 3 or the server 6 determines that the power is lost a predetermined amount of times, then the logic unit 3 or the server 6 generates a second grade warning. Preferably the predetermined amount of times is two out of ten times, but can be an adapted value such as one out of 10 times or 3 out of ten times. One other possibility is that the predetermined value is one out of one time.

The implementation of the above mentioned and discussed method is best performed in the form of a computer program product. That is that the method should be executed in hardware of a computer, or a server.

The material handling vehicle 1 discussed can itself execute the method of the invention in its standard logic unit 3. Or the material handling vehicle comprises an interface 5 for sending the data to a server 6 that can execute said method.

A control system 18 comprises an interface 5 for transmitting the warnings of the method to a remote data logic unit 6. The remote data logic unit 6 can either be passive or active i.e. it can store and indicate the data of the battery status already assessed locally at the client logic unit 3 of a material handling vehicle 1 or it can perform the calculation itself.

When the control system 18 has a value of the battery status of a material handling vehicle 1 this status is presented to a user by an indication unit 19. The presentation is preferably made through the http or https protocol on a web server, so that the information is available to an administrator through a web page.

A device 17, 18 for assessment of the battery status comprises the discussed battery discharge indicator 2, a logic unit 3 of the material handling vehicle and calculation unit 3, 6 for assessment of the battery status. The device uses the collected data for a calculation of the battery status as mentioned in the context of the method described above. See Fig 4 and 8.

The calculation unit is generally comprised in the logic unit 3 or the server 6.

**Claims**

1. Method for assessment of battery status in an electric material handling vehicle 1, comprising the steps of

- registering battery discharge rate data by means of a battery discharge indicator (2)
- registering operational data of the material handling vehicle by an operational data unit (4), and
- assessing the battery status based on the registered battery discharge rate data and the operational data of the material handling vehicle by a logic unit (3) or a server (6), *characterized in* that

the registering of operational data comprises registering data related to at least the following parameters: lift time and drive time so as to take into account how the material handling vehicle is operated, wherein the battery status is an assessment of the condition of the battery which condition is based on the operation and maintenance of the battery, wherein the battery status provides a tool for decisions on maintenance or battery change, wherein the assessment of the battery status comprises obtaining a rapid discharge warning based on the battery discharge rate, drive time and lift time,

the method further comprising a step of:

indicating the rapid discharge warning obtained by the logic unit (3) or the server (6) by a battery status indicator (19),
where the obtaining of the rapid discharge warning comprises the steps of:

- determining by the logic unit (3) or server (6) if battery discharge rate changes from predetermined value A to predetermined value B without an intermediate value C, where C > A,
- registration by the operational unit (4) of parameter D where D = Drive and lift time for a battery discharge rate changing from A to B,
- calculating by the logic unit 3 or server 6 a parameter Y where Y = D * N / E where N and E are constants, and
- determining by the logic unit 3 or server 6 whether the parameter Y is less than a predetermined value G.

2. Method according to claim 1 wherein operational data related to at least one of the parameters: accumulated lift time, accumulated drive time, and driver identification, such as a driver pin, is registered by the operational data unit (4), at the start of a work pass.

3. Method according to claims 1-2 wherein operational data related to at least one of the parameters, time stamp, work pass ending type is registered at end of work pass, by the operational data unit (4).

4. Method according to claim 3 where in the work pass ending type registered by the operational data unit (4), has at least three possible values denoting, normal ending, timer logoff ending and power loss ending.

5. Method according to claims 1-4 wherein the method comprises determining by the logic unit (3) or the server (6), a warning level based on the calculated battery status and indicating the warning level.

6. Method according to claim 5 wherein the said warning has at least two levels, a first grade and a second grade and that these two warning's is displayed in a different manner, and that said warnings arises from different values of said battery status, calculated by said logic unit (3) or said server (6).

7. Method according to claims 1-6 where in the assessment of the battery status comprises:

- registering an operational data comprising measuring power off time by the operational data a unit (4)
- calculation of battery status based on power off time information by the logic unit (3) or server (6)

and further

- indication of a short time charging warning based on said power off time by a battery discharge indicator (19)

8. Method according to claim 1-7 where in registering battery discharge rate data comprises:

- registration of battery discharge rate at end of working pass by an operational data unit (4) indicated by a BDI (2)

registering operational data comprises:

- registering of power off time by the operational data unit (4)

calculating the battery status by the logic unit (3) or the server (6) comprises:

- determining by the logic unit (3) or the server (6) whether the power off time between two working passes has been less than a predetermined value.
- determining by the logic unit (3) or the server (6) whether the battery discharge rate is lower than a predetermined value
- determining by the logic unit (3) or the server (6) whether the battery discharge rate is comprised in a predetermined interval at the start of new working pass.

9. Method according to claim 8 wherein a first grade short time charging warning is generated if

- the logic unit (3) or the server (6) determines that the conditions of claim 10 has been valid at least a predetermined number of times during the last predetermined amount of working passes.

10. Method according to claims 9 wherein a second grade short time charging warning is generated if the:

- the logic unit (3) or the server (6) determines that the conditions of claim 10 has been valid at least a predetermined number of times, that is larger than the value for the first grade short time charging warning, during the last predetermined amount of working passes.

**11.** Method according to any of the preceding claims wherein a first grade rapid discharge warning is generated by the logic unit (3) or the server (6) if the conditions of claim 1 are met predetermined amount of times of changes from A to B.

**12.** Method according to claim 11, wherein a second grade rapid discharge warning is generated by the logic unit (3) or the server (6) if the following condition is complied with:

- parameter Y is less predetermined value H where H is less than G.

and this condition are determined by the logic unit (3) or the server (6) is met a predetermined amount of times.

**13.** Method according to any of the preceding claims, wherein a power loss warning is generated based on power loss and one other condition, such as a condition of claim 9 or 11.

**14.** Method according to claim 13 wherein a first grade power loss warning is generated as a result of the following further steps:

- Determining by the logic unit (3) or server (6) that working pass is ongoing.
- Determining by the logic unit (3) or server (6) that power is lost.
- Determine by the logic unit (3) or server (6) if the conditions above are met a predetermined amount of times.

**15.** Method according to any of the claims above wherein further comprised is an interface (5) for communication with the said server (6), said interface (5) is preferably of wireless kind being able to communicate over wireless systems such as, GSM, GPRS, LAN, Satellite networks.

**16.** Method according to any of the claims above wherein said interface (5) is arranged to use a Short Message Text Service for communicating said data.

**17.** A computer program product adapted to perform the method of claims 1-16.

**18.** Device (17, 18) adapted to perform the method of any of claims 1 - 16 for assessment of battery status of a vehicle such as an electric material handling vehicle (1), comprising a battery discharge indicator (2), an operational data unit (4) for collecting operational data in the material handling vehicle (1), and a logic unit (3) or a remote server (6), for performing a calculation for assessment of the battery status **characterized in that** the device is arranged for using the collected data for a battery status calculation, where said logic unit (3) or remote server (6) calculates the status of the battery based on measurement of an operational condition registered by the operational data unit (4) and a battery discharge rate value, indicated by the battery discharge indicator (2).

**19.** The device according to claim 18 comprising an interface (5) for transmitting the registered data or the warnings of said method to said remote server (6).

**20.** The device according to claim 18 or 19 comprising a battery status indicator (19) for presenting transmitted data or the warnings to a user after execution of said method.

**Patentansprüche**

**1.** Ein Verfahren zur Beurteilung eines Batteriestatus eines elektrischen Materialtransportfahrzeugs 1 umfassend die Schritte

- Verzeichnen von Daten einer Batterieentladungsrate durch Mittel eines Batterieentladeindikators (2)
- Verzeichnen von Betriebsdaten des Materialtransportfahrzeugs durch eine Betriebsdateneinheit (4), und
- Beurteilen des Batteriestatus basierend auf den verzeichneten Daten der Batterieentladungsrate und den Betriebsdaten des Materialtransportfahrzeugs durch eine Logikeinheit (3) oder einen Server (6), **dadurch gekennzeichnet, dass**

das Verzeichnen von Betriebsdaten ein Verzeichnen von zumindest die folgenden Parameter betreffenden Daten umfasst: eine Hebezeit und eine Fahrtzeit, sodass berücksichtigt wird, wie das Materialtransportfahrzeug betrieben wird,
wobei der Batteriestatus eine Beurteilung des Zustands der Batterie ist, wobei der Zustand auf dem Betrieb und der Wartung der Batterie basiert,
wobei der Batteriestatus ein Hilfsmittel für Entscheidungen bezüglich Wartung oder Batterieaustausch bereitstellt,
wobei die Beurteilung des Batteriestatus ein Erfassen einer Schnellentladungswarnung basierend auf der Batterieentladungsrate, der Fahrzeit und der Hebezeit umfasst,
wobei das Verfahren weiter einen Schritt umfasst:

Anzeigen der durch die Logikeinheit (3) oder den Server (6) durch einen Batteriestatusindikator (19) erfassten Schnellentladungswarnung,
wobei das Erfassen der Schnellentladungswarnung die Schritte umfasst:

- Bestimmen durch die Logikeinheit (3) oder den Server (6), falls die Batterieentladungsrate sich von einem vorbestimmten Wert A zu einem vorbestimmten Wert B ohne einen Zwischenwert C ändert, wobei C > A,
- Verzeichnung durch die Betriebseinheit (4) eines Parameters D, wobei D = Drive (Fahr-) und Hebezeit für eine sich von A zu B verändernde Batterieentladungsrate ist,
- Berechnen durch die Logikeinheit 3 oder den Server 6 eines Parameters Y, wobei Y = D*N/E, wobei N und E Konstanten sind, und
- Bestimmen durch die Logikeinheit 3 oder den Server 6, ob der Parameter Y geringer als ein vorbestimmter Wert G ist.

2. Das Verfahren gemäß Anspruch 1, wobei Betriebsdaten, welche zumindest einen der Parameter: akkumulierte Hebezeit, akkumulierte Fahrzeit und eine Fahreridentifikation wie beispielsweise einen Fahrer-PIN betreffen, durch die Betriebsdateneinheit (4) am Beginn eines Arbeitsgangs verzeichnet werden.

3. Das Verfahren gemäß den Ansprüchen 1-2, wobei Betriebsdaten, welche zumindest einen der Parameter, Zeitstempel, Arbeitsgang-Beendigungstyp, betreffen, am Ende eines Arbeitsgangs durch die Betriebsdateneinheit (4) verzeichnet werden.

4. Das Verfahren gemäß Anspruch 3, wobei der durch die Betriebsdateneinheit (4) verzeichnete Arbeitsgang-Beendigungstyp zumindest drei mögliche Werte aufweist, welche eine normale Beendigung, eine Timer-Logout-Beendigung und eine Energieverlust-Beendigung bezeichnen.

5. Das Verfahren gemäß den Ansprüchen 1-4, wobei das Verfahren ein Bestimmen durch die Logikeinheit (3) oder den Server (6) einer Warnungsstufe basierend auf dem berechneten Batteriestatus und ein Anzeigen der Warnungsstufe umfasst.

6. Das Verfahren gemäß Anspruch 5, wobei die Warnung zumindest zwei Stufen aufweist, einen ersten Grad und einen zweiten Grad, und dass diese zwei Warnungen in unterschiedlicher Weise angezeigt werden, und dass die Warnungen aus unterschiedlichen Werten des Batteriestatus, welche durch die Logikeinheit (3) oder den Server (6) berechnet werden, hervorgehen.

7. Das Verfahren gemäß den Ansprüchen 1-6, wobei die Beurteilung des Batteriestatus umfasst:

- Verzeichnen von Betriebsdaten, welche ein Messen einer Ausschaltzeit durch die Betriebsdateneinheit (4) umfassen,

- Berechnen des Batteriestatus basierend auf Informationen der Ausschaltzeit durch die Logikeinheit (3) oder den Server (6)

und weiter

- Anzeigen einer Kurzzeitladungswarnung basierend auf der Ausschaltzeit durch einen Batterieentladungsindikator (19)

8. Das Verfahren gemäß den Ansprüchen 1-7, wobei das Verzeichnen von Daten einer Batterieentladungsrate umfasst:

- Verzeichnen einer durch einen BDI (2) angezeigten Batterieentladungsrate am Ende eines Arbeitsgangs durch eine Betriebsdateneinheit (4);

Verzeichnen von Betriebsdaten umfasst:

- Verzeichnen einer Ausschaltzeit durch die Betriebsdateneinheit (4);

Berechnen des Batteriestatus durch die Logikeinheit (3) oder den Server (6) umfasst:

- Bestimmen durch die Logikeinheit (3) oder den Server (6), ob die Ausschaltzeit zwischen zwei Arbeitsgängen geringer als ein vorbestimmter Wert war,
- Bestimmen durch die Logikeinheit (3) oder den Server (6), ob die Batterieentladungsrate geringer als ein vorbestimmter Wert ist,
- Bestimmen durch die Logikeinheit (3) oder den Server (6), ob die Batterieentladungsrate in einem vorbestimmten Intervall an dem Beginn eines neuen Arbeitsgangs umfasst ist.

9. Das Verfahren gemäß Anspruch 8, wobei eine Kurzzeitladungswarnung eines ersten Grads erzeugt wird, falls

- die Logikeinheit (3) oder der Server (6) bestimmt, dass die Bedingungen aus Anspruch 10 zumindest eine vorbestimmte Anzahl von Malen während der letzten vorbestimmten Anzahl von Arbeitsgängen gültig waren.

10. Das Verfahren gemäß Anspruch 9, wobei eine Kurzzeitladungswarnung eines zweiten Grads erzeugt wird, falls

- die Logikeinheit (3) oder der Server (6) bestimmt, dass die Bedingungen aus Anspruch 10 zumindest eine vorbestimmte Anzahl von Malen, welche größer als der Wert für die Kurzzeitladungswarnung des ersten Grads ist, während der letzten vorbestimmten Anzahl von Arbeitsgängen gültig waren.

11. Das Verfahren gemäß einem der vorstehenden Ansprüche, wobei eine Schnellentladungswarnung eines ersten Grads durch die Logikeinheit (3) oder den Server (6) erzeugt wird, falls die Bedingungen aus Anspruch 1 eine vorbestimmte Anzahl von Malen von Änderungen von A nach B erfüllt sind.

12. Das Verfahren gemäß Anspruch 11, wobei eine Schnellentladungswarnung eines zweiten Grads durch die Logikeinheit (3) oder den Server (6) erzeugt wird, falls die folgende Bedingung eingehalten wird:

   - Parameter Y ist geringer vorbestimmter Wert H, wobei H geringer als G ist

   und diese Bedingung wird durch die Logikeinheit (3) oder den Server (6) bestimmt, wird eine vorbestimmte Anzahl von Malen erfüllt.

13. Das Verfahren nach einem der vorstehenden Ansprüche, wobei eine Energieverlustwarnung basierend auf einem Energieverlust und einer anderen Bedingung wie beispielsweise einer Bedingung aus Anspruch 9 oder 11 erzeugt wird.

14. Das Verfahren gemäß Anspruch 13, wobei eine Energieverlustwarnung eines ersten Grads als ein Ergebnis der folgenden weiteren Schritte erzeugt wird:

   - Bestimmen durch die Logikeinheit (3) oder den Server (6), dass ein Arbeitsgang im Gange ist;
   - Bestimmen durch die Logikeinheit (3) oder den Server (6), dass Energie verloren wird;
   - Bestimmen durch die Logikeinheit (3) oder den Server (6), ob die obigen Bedingungen eine vorbestimmte Anzahl von Malen erfüllt sind.

15. Das Verfahren gemäß einem der obigen Ansprüche, wobei weiter eine Schnittstelle (5) zur Kommunikation mit dem Server (6) umfasst ist, wobei die Schnittstelle (5) vorzugsweise eines drahtlosen Typs ist, welche geeignet ist über drahtlose Systeme wie beispielsweise GSM, GPRS, LAN, Satellitennetzwerke zu kommunizieren.

16. Das Verfahren gemäß einem der obigen Ansprüche, wobei die Schnittstelle (5) zum Verwenden eines Kurznachrichtendiensts zum Kommunizieren der Daten vorgesehen ist.

17. Ein Computerprogrammprodukt daran angepasst das Verfahren aus den Ansprüchen 1-16 auszuführen.

18. Vorrichtung (17, 18) daran angepasst, das Verfahren eines der Ansprüche 1-16 zur Beurteilung eines Batteriestatus eines Fahrzeugs wie beispielsweise einem elektrischen Materialtransportfahrzeug (1), welches einen Batterieentladungsindikator (2), eine Betriebsdateneinheit (4) zum Sammeln von Betriebsdaten in dem Materialtransportfahrzeug (1) und eine Logikeinheit (3) oder einen Remote-Server (6) zum Ausführen einer Berechnung für eine Beurteilung des Batteriestatus umfasst, **dadurch gekennzeichnet, dass** die Vorrichtung zum Verwenden der gesammelten Daten für eine Batteriestatusberechnung vorgesehen ist, wobei die Logikeinheit (3) oder der Remote-Server (6) den Status der Batterie basierend auf einer Messung einer durch die Betriebsdateneinheit (4) verzeichneten Betriebsbedingung und einem durch den Batterieentladungsindikator (2) angezeigten Wert einer Batterieentladungsrate berechnet.

19. Die Vorrichtung gemäß Anspruch 18 umfassend eine Schnittstelle (5) zum Übermitteln der verzeichneten Daten oder der Warnungen der Verfahren an den Remote-Server (6).

20. Die Vorrichtung gemäß Anspruch 18 oder 19 umfassend einen Batteriestatusindikator (19) zum Präsentieren von übermittelten Daten oder den Warnungen an einen Anwender nach der Ausführung des Verfahrens.

**Revendications**

1. Procédé d'évaluation de l'état d'une batterie dans un véhicule de manutention électrique (1), comprenant les étapes consistant à :

   - enregistrer des données de vitesse de décharge d'une batterie au moyen d'un indicateur de décharge de batterie (BDI) (2) ;
   - enregistrer des données opérationnelles du véhicule de manutention à l'aide d'une unité de données opérationnelles (4) ; et
   - évaluer l'état d'une batterie sur la base des données de vitesse de décharge d'une batterie et des données opérationnelles du véhicule de manutention enregistrées par une unité logique (3) ou par un serveur (6), **caractérisé en ce que** :

   l'étape consistant à enregistrer des données opérationnelles comprend une étape consistant à enregistrer des données qui se rapportent au moins aux paramètres suivants : durée de levage et durée de conduite, de façon à tenir compte de la façon dont le véhicule de manutention est exploité ;

dans lequel l'état d'une batterie est une évaluation de l'état de la batterie, lequel état est basé sur le fonctionnement et sur l'entretien de la batterie ;

dans lequel l'état d'une batterie fournit un outil destiné à prendre des décisions en ce qui concerne l'entretien ou le remplacement d'une batterie ;

dans lequel l'évaluation de l'état d'une batterie comprend l'obtention d'une alerte de décharge rapide sur la base de la vitesse de décharge d'une batterie, de la durée de conduite et de la durée de levage ;

le procédé comprenant en outre une étape consistant à :

- indiquer l'alerte de décharge rapide obtenue par l'unité logique (3) ou par le serveur (6) à l'aide d'un indicateur de l'état d'une batterie (19) ;

dans lequel l'étape consistant à obtenir l'alerte de décharge rapide comprend les étapes consistant à :

- déterminer à l'aide de l'unité de logique (3) ou du serveur (6) si la vitesse de décharge d'une batterie varie à partir d'une valeur prédéterminée A jusqu'à une valeur prédéterminée B sans valeur intermédiaire C, dans lequel C > A;
- enregistrer, à l'aide de l'unité opérationnelle (4), un paramètre D, dans lequel D = durée de conduite et de levage lorsque la vitesse de décharge d'une batterie varie de A à B ;
- calculer, à l'aide de l'unité logique (3) ou du serveur (6), un paramètre Y dans lequel $Y = D * N / E$, où N et E sont des constantes ; et
- déterminer, à l'aide de l'unité logique (3) ou du serveur (6), si le paramètre Y est inférieur à une valeur prédéterminée G.

2. Procédé selon la revendication 1, dans lequel les données opérationnelles qui se rapportent à l'un au moins des paramètres suivants : durée de levage accumulée, durée de conduite accumulée, et identification du conducteur, telle qu'une épinglette de conducteur, sont enregistrées par l'unité de données opérationnelles (4), au début d'une séance de travail.

3. Procédé selon la revendication 1 ou la revendication 2, dans lequel les données opérationnelles qui se rapportent à l'un au moins des paramètres suivants : estampille temporelle, type de fin de séance de travail, son enregistrées à la fin de la séance de travail, par l'unité de données opérationnelles (4).

4. Procédé selon la revendication 3, dans lequel le type de fin de séance de travail enregistré par l'unité de données opérationnelles (4), présente au moins trois valeurs possibles, fin normale, fin suite au dépassement d'un temporisateur et fin suite à une perte de puissance.

5. Procédé selon l'une quelconque des revendications 1 à 4, dans lequel le procédé comprend une étape consistant à déterminer, à l'aide de l'unité de logique (3) ou du serveur (6), un niveau d'alerte sur la base de l'état calculé d'une batterie, et à indiquer le niveau d'alerte.

6. Procédé selon la revendication 5, dans lequel ladite alerte présente au moins deux niveaux, un premier degré et un second degré et ces deux alertes sont affichées d'une façon différente, et lesdites alerte surviennent suite à des valeurs différentes dudit état d'une batterie, calculées par ladite unité logique (3) ou par ledit serveur (6).

7. Procédé selon l'une quelconque des revendications 1 à 6, dans lequel l'évaluation de l'état d'une batterie comprend les étapes consistant à :

- enregistrer des données opérationnelles y compris une étape consistant à mesurer une durée de mise hors tension à l'aide de l'unité de données opérationnelles (4) ;
- calculer un état d'une batterie sur la base des informations de durée de mise hors tension à l'aide de l'unité logique (3) ou du serveur (6) ;

et comprenant en outre une étape consistant à :

- indiquer une alerte de charge de durée courte sur la base de ladite durée de mise hors tension, à l'aide d'un indicateur de décharge de batterie (19).

8. Procédé selon l'une quelconque des revendications 1 à 7, dans lequel :

l'étape consistant à enregistrer des données de vitesse de décharge d'une batterie comprend les étapes consistant à :

- enregistrer une vitesse de décharge d'une batterie à la fin d'une séance de travail à l'aide d'une unité de données opérationnelles (4), indiquée par un BDI (2) ;

l'étape consistant à enregistrer des données opérationnelles comprend une étape consistant à :

- enregistrer une durée de mise hors tension à l'aide de l'unité de données opérationnelles (4) ;

l'étape consistant à calculer l'état d'une batterie à l'aide de l'unité de logique (3) ou du serveur (6) comprend les étapes consistant à :

- déterminer, à l'aide de l'unité de logique (3) ou du serveur (6), si la durée de mise hors tension entre deux séances de travail a été inférieure à une valeur prédéterminée ;
- déterminer, à l'aide de l'unité de logique (3) ou du serveur (6), si la vitesse de décharge d'une batterie est inférieure à une valeur prédéterminée ;
- déterminer, à l'aide de l'unité de logique (3) ou du serveur (6), si la vitesse de décharge d'une batterie se situe à l'intérieur d'un intervalle prédéterminé au début d'une séance de travail.

9. Procédé selon la revendication 8, dans lequel une alerte de charge de durée courte de premier degré, est générée si :

- l'unité logique (3) ou le serveur (6) détermine que les conditions de la revendication 10 ont été valides au moins un certain nombre de fois prédéterminé au cours de la dernière quantité prédéterminée de séances de travail.

10. Procédé selon la revendication 9, dans lequel une alerte de charge de durée courte de second degré, est générée si :

- l'unité logique (3) ou le serveur (6) détermine que les conditions de la revendication 10 ont été valides au moins un certain nombre de fois prédéterminé qui est supérieur à la valeur de la première alerte de charge de durée courte de premier degré, au cours de la dernière quantité prédéterminée de séances de travail.

11. Procédé selon l'une quelconque des revendications précédentes, dans lequel une alerte de décharge rapide de premier degré est générée par l'unité logique (3) ou par le serveur (6) si les conditions de la revendication 1 correspondent à un certain nombre de fois prédéterminé de variations de A à B.

12. Procédé selon la revendication 11, dans lequel une alerte de décharge rapide de second degré est générée par l'unité de logique (3) ou par le serveur (6) si la condition suivante est satisfaite :

- le paramètre Y est inférieur à une valeur prédéterminée H, dans lequel H est inférieure à G ;

et si cette condition déterminée par l'unité logique (3) ou par le serveur (6) est satisfaite un certain nombre de fois prédéterminé.

13. Procédé selon l'une quelconque des revendications précédentes, dans lequel une alerte de perte de puissance est générée sur la base d'une perte de puissance et d'une autre condition, telle qu'une condition selon les revendications 9 ou 11.

14. Procédé selon la revendication 13, dans lequel une alerte de perte de puissance de premier degré est générée en raison des autres étapes suivantes consistant à :

- déterminer, à l'aide de l'unité logique (3) ou du serveur (6), qu'une séance de travail est en cours ;
- déterminer, à l'aide de l'unité logique (3) ou du serveur (6), que la puissance est perdue ;
- déterminer, à l'aide de l'unité logique (3) ou du serveur (6), que les conditions ci-dessus sont satisfaites un certain nombre de fois prédéterminé.

15. Procédé selon l'une quelconque des revendications précédentes, comprenant en outre une interface (5) de communication avec ledit serveur (6), ladite interface (5) étant de préférence du genre sans fil qui peut communiquer sur des systèmes sans fil tels que des réseaux, GSM, GPRS, LAN, et de satellites.

16. Procédé selon l'une quelconque des revendications précédentes, dans lequel ladite interface (5) est agencée de façon à utiliser un service de texte de messages courts afin de communiquer lesdites données.

17. Produit programme informatique adapté de façon à exécuter le procédé selon l'une quelconque des revendications 1 à 16.

18. Dispositif (17, 18) adapté de façon à exécuter le procédé selon l'une quelconque des revendications 1 à 16, destiné à évaluer l'état d'une batterie d'un véhicule tel qu'un véhicule de manutention électrique (1), comprenant un indicateur de décharge de batterie (2), une unité de données opérationnelles (4) destinée à collecter des données opérationnelles dans le véhicule de manutention (1), et une unité logique (3) ou un serveur distant (6), destiné à exécuter un calcul d'évaluation de l'état d'une batterie, **caractérisé en**

**ce que** le dispositif est agencé de façon à utiliser les données collectées afin de calculer l'état d'une batterie, où ladite unité logique (3) ou ledit serveur distant (6) calcule l'état de la batterie sur la base d'une mesure d'une condition opérationnelle enregistrée par l'unité de données opérationnelles (4), et d'une valeur de vitesse de décharge de batterie, indiquée par l'indicateur de décharge de batterie (2).

19. Dispositif selon la revendication 18, comprenant une interface (5) destinée à transmettre audit serveur distant (6) les données enregistrées ou les alertes dudit procédé.

20. Dispositif selon les revendications 18 ou 19, comprenant un indicateur d'état de batterie (19) destiné à présenter les données ou les alertes transmises à un utilisateur après l'exécution dudit procédé.

16

1

15

14

Fig 1

U1

U2

Fig. 2

Fig. 3

6

2

| Remote server | | BDI |

4

| Interface | ⟷ | Logic unit | ⟷ | Operational data unit |

5

3

17

Fig. 4

7

8

9

| Operator identification unit | Work pass determination unit | Unit for determination of number of lifts |

17

13

Operational data unit

| Drive time determination unit | | Unit for determination of number of drives |

| Battery size determination unit | Lift time determination unit | Power off time determiniation unit |

10

11

12

4

Fig 5

Fig. 6

```
┌─────────────────────────────────────┐
│       Assesment of battery status    │
└─────────────────────────────────────┘

┌───────────────────────┐
│      Registraton of    │
│   battery discharge    │
│    rate data by BDI    │
└───────────────────────┘

┌───────────────────────┐
│    Registration of an  │
│   operational data by  │
│     the operational    │
│       data unit        │
└───────────────────────┘

┌───────────────────────┐
│     Calculation of a   │
│     battery status by  │
│   the logic unit or the│
│         server         │
└───────────────────────┘
```

Fig. 7

Fig. 8

**EP 2 096 453 B1**

## REFERENCES CITED IN THE DESCRIPTION

### Patent documents cited in the description

- US 5349535 A
- US 20040100225 A1
- US 20070182576 A1